# EUROPÄISCHE PATENTSCHRIFT

(11) **EP 2 603 957 B1**
(45) Veröffentlichungstag und Bekanntmachung des Hinweises auf die Patenterteilung: **15.04.2015**
(21) Anmeldenummer: 11757193.5
(22) Anmeldetag: 12.08.2011
(51) Int. Cl.: H01R 33/00

(54) **RÜCKSEITIGE ANBINDUNG VON LED-MODULEN**
REAR CONNECTION FOR A LED SUPPORT
CONNECTION PAR L'ARRIÈRE D'UN MODULE AVEC LED

(30) Priorität: 13.08.2010 DE 102010034306
(43) Veröffentlichungstag der Anmeldung: 19.06.2013
(73) Patentinhaber: Siteco Beleuchtungstechnik GmbH, 83301 Traunreut (DE)
(72) Erfinder: WUPPINGER, Bernhard, 83278 Traunstein (DE); PRODELL, Peter, 83308 Trostberg (DE); HOLZBAUER, Jochen, 83278 Traunstein (DE)
(74) Vertreter: Schmidt, Steffen
(86) Internationale Anmeldenummer: PCT/EP2011/063927
(87) Internationale Veröffentlichungsnummer: WO 2012/020119

(56) Entgegenhaltungen:
- EP-A2- 1 484 547
- US-A- 5 038 255
- US-A1- 2004 218 389
- US-A1- 2005 052 865
- US-B1- 6 502 975

## Beschreibung

Die Erfindung betrifft ein Leuchtenmodul, welches mehrere auf einer Platine angeordnete LEDs (light emitting diodes, worunter auch organic light emitting diodes zu verstehen sind) aufweist. Ferner betrifft die Erfindung eine Leuchte, die eines oder mehrere dieser Leuchtenmodule aufweist.

In der Leuchtentechnik ist bekannt, Leuchten mit LEDs als Leuchtmittel dadurch zu bilden, dass eine Vielzahl von LEDs auf Modulen, insbesondere auf einer gemeinsamen Platine, angeordnet sind. Die Platine besitzt in der Regel auf der Bestückungsseite elektrische Anschlüsse, mit denen sie an die Stromversorgung der Leuchte angeschlossen werden können. Der Aufwand zur Montage dieser Module ist verhältnismäßig hoch. Die Montage kann in der Regel nur von einem Fachmann vorgenommen werden, da auf der Platine offen liegende stromführende Leitungen vorhanden sind. Ferner ist die Verlegung der Anschlusskabel aufwendig, weil die Anschlusskabel über die mit LEDs besetzte Bestückungsseite der Platine verlegt werden müssen, die im sichtbaren Bereich der Leuchte liegt. Selbst wenn das Anschlusskabel seitlich an der Platine verlegt wird, ist es häufig dennoch von außen sichtbar und die Verdrahtung kann nur von einem Fachmann vorgenommen werden.

US 2005/0052865 A1 offenbart ein Leuchtengehäuse mit einer integrierten LED-Trägerstruktur. Ein Rahmen aus elektrischen Leitern dient zur Versorgung von mehreren LEDs. Ferner sind Anschlüsse zur elektrischen Versorgung der LEDs an dem Rahmen vorgesehen. Der Rahmen wird in dem Lampengehäuse eingegossen. Ferner sind ein positiver und negativer Anschluss eingegossen oder mechanisch mit dem Gehäuse verbunden und elektrisch an den Leiter des Leiterrahmens in Löchern des Leiterrahmens angeschlossen.

US 5,038,255 offenbart eine Fahrzeuglampe. Elektrische Leiterbahnen sind auf einer Innenfläche eines Gehäuses aufgedruckt. Auf den Leiterbahnen sind LEDs angeschlossen. Auf der Rückseite des Gehäuses ist ein Steckkontakt auf zwei Anschlüssen aus Metall eingesteckt, die in das Gehäuse eingegossen sind und aus der Rückseite des Gehäuses hervorstehen.

US 6,502,975 B1 offenbart eine diebstahlsichere Beleuchtungseinrichtung insbesondere für Fahrzeuge. Eine Beleuchtungseinrichtung umfasst eine Platine mit LEDs sowie eine Steckverbindung 134 für die elektrische Kontaktierung. Die Steckverbindung ist mit den LEDs durch die Platine verbunden.

Aufgabe der vorliegenden Erfindung ist es, Leuchtenmodule mit LED-Bestückung zu bilden, welche leichter zu montieren sind und eine höhere Betriebssicherheit gewähren.

Die Erfindung wird gelöst durch eine Leuchte, die ein oder mehrere Leuchtenmodule zum Anschluss an eine Leuchte aufweist, wobei das wenigstens eine Leuchtenmodul eine Platine mit einer Bestückungsseite aufweist, auf der mehrere LEDs und elektrische Leiterbahnen zum elektrischen Kontaktieren der LEDs angeordnet sind, wobei die Platine wenigstens eine Öffnung aufweist und ein Kupplungsstück einer Steckeryerbindung an der Platine im Bereich der Öffnung fest montiert ist, in welches ein leuchtenseitiges Gegenkupplungsstücks, welches an einem Gehäuseabschnitt der Leuchte fest vorgesehen ist, von der der Bestückungsseite gegenüberliegenden Rückseite der Platine eingreifen kann, wobei durch die Öffnung eine elektrische Verbindung von der Bestückungsseite zu der Rückseite der Platine gebildet wird, um die LEDs von der Rückseite des Leuchtenmoduls mit elektrischer Leistung zu versorgen.

Die Erfindung macht davon Gebrauch, dass das Leuchtenmodul auf der Bestückungsseite, die in den sichtbaren Bereich der Leuchte weist, nicht kontaktiert werden muss, sondern von der Rückseite kontaktiert wird. Dazu ist eine Öffnung in der Platine vorgesehen, um die elektrische Verbindung zur Rückseite durchzuführen. Dadurch ist es möglich, eine aufwendige und entsprechend teure doppelseitig leitende Platine zu vermeiden. Ferner wurde erkannt, dass die rückseitige Kontaktierung des Leuchtenmoduls weitere Vorteile mit sich bringt, die eine einfachere Isolierung des Bauteils und eine leichtere Handhabung des Bauteils ermöglichen.

Gemäß einer bevorzugten Ausführungsform ist das Kupplungsstück der Steckverbindung im Bereich der Öffnung auf der Bestückungsseite auf der Platine montiert und greift von der Bestückungsseite durch die Öffnung hindurch. Dadurch sind die zur Montage des Leuchtenmoduls erforderlichen elektrischen Anschlüsse vollständig von der Rückseite zugänglich. Gemäß einer alternativen Ausführungsform kann ein Kupplungsstück der Steckverbindung im Bereich der Öffnung auf der Bestückungsseite auch derart montiert sein, dass ein leuchtenseitiges Gegenkupplungsstück durch die Öffnung zum Eingriff in das Kupplungsstück hindurchgeführt werden kann. In diesem Fall ragt zwar das modulseitige Kupplungsstück nicht auf die Rückseite der Platine hervor, dennoch ist die Zugänglichkeit zu dem Kupplungsstück von der Rückseite durch die Öffnung gewährleistet. Letzteres hat den Vorteil, dass die Rückseite der Platine eben ist und sie somit leicht mit einem Kühlkörper in Kontakt gebracht werden kann.

Gemäß einer weiteren bevorzugten Ausführungsform ist das Kupplungsstück im Bereich der wenigstens einen Öffnung auf der Rückseite der Platine montiert und die elektrische Verbindung verbindet das Kupplungsstück mit der Bestückungsseite durch die wenigstens eine Öffnung. Bei dieser Ausführungsform ist die elektrische Verbindung durch eine feste Verdrahtung gebildet, während bei den beiden vorhergehend beschriebenen bevorzugten Ausführungsformen die elektrische Verbindung durch das Kupplungsstück bzw. das Gegenkupplungsstück gebildet wird. Auch bei dieser Ausführungsform ist es nicht notwendig, dass auf der Rückseite der Platine elektrische Leiterbahnen vorhanden sind. Die elektrische Verbindung kann in Form einer Festverdrahtung direkt von dem Kupplungsstück durch die Öffnung zu der Bestückungsseite geführt sein und nur auf der Bestückungsseite mit elektrischen Leiterbahnen in Kontakt stehen.

Gemäß einer bevorzugten Ausführungsform ist die Steckverbindung dafür eingerichtet, das Leuchtenmodul mechanisch an der Leuchte zu halten. In diesem Fall müssen die Leuchtenmodule zur Montage lediglich in die Leuchte eingesteckt werden. Dies ist häufig noch am Montageort der Leuchte möglich. Gegebenenfalls kann diese Arbeit sogar von einem Nichtfachmann vorgenommen werden. Die Montage der Leuchtenmodule ist vergleichbar einfach, wie das Auswechseln eines herkömmlichen Leuchtmittels in einer Leuchte.

Gemäß einer bevorzugten Ausführungsform ist die Platine des Leuchtenmoduls nur auf der Bestückungsseite leitend ausgebildet. Im Unterschied zu Platinen, die auf zwei Seiten leitfähig ausgebildet sind und Durchkontaktierungen aufweisen, sind die einseitig leitenden Platinen wesentlich kostengünstiger. Ferner bieten sie den Vorteil, dass keinerlei elektrischen Kontakte auf die Rückseite des Leuchtenmoduls weisen, so dass diese Seite zur Isolierung des Leuchtenmoduls keiner separaten Bearbeitung bedarf. Das Leuchtenmodul kann auf der Rückseite einfach von einer nichtleitenden Oberfläche der Platine gebildet werden und benötigt daher keine gesonderte Isolierschicht oder ein separates Gehäuse zur Isolierung.

Gemäß einer bevorzugten Ausführungsform ist zwischen dem Kupplungsstück und der Platine eine Isolierung oder eine Dichtung angeordnet. Beispielsweise kann das Kupplungsstück auf der Bestückungsseite oder der Rückseite mittels eines Klebstoffs angeklebt sein. Der Klebstoff kann gleichzeitig die Funktion einer elektrischen Isolierung und/oder einer Dichtung haben. Dadurch kann ein Eindringen von Staub oder Feuchtigkeit zwischen dem Kupplungsstück und der Platine verhindert werden. Diese Ausführungsform eignet sich insbesondere im Zusammenhang mit den nachfolgend beschriebenen bevorzugten Ausführungsformen, in denen die Platine wenigstens auf der leitenden Bestückungsseite mit einer Isolierung, die ggf. staub- und/oder feuchtigkeitsdicht ist, versehen ist.

Gemäß einer bevorzugten Ausführungsform ist die Platine auf der Bestückungsseite vollständig oder teilweise mit einer elektrischen Isolierung überzogen. Vorzugsweise ist die Isolierung durch eine Vergussmasse, insbesondere eine transparente Vergussmasse, gebildet. Bei einer Verwendung einer transparenten Vergussmasse lässt sich das gesamte Leuchtenmodul einschließlich der LEDs eingießen. Dies ist eine besonders kostengünstige und effiziente Art, um das Leuchtenmodul zu isolieren. Die Isolierung kann so ausgebildet sein, dass sie gegen eine elektrostatische Entladung (ESD) geschützt ist. In diesem Fall kann die Montage der Leuchtenmodule sogar von einem Nichtfachmann vorgenommen werden.

Gemäß einer weiteren Ausführungsform kann eine Dichtung auf der der Bestückungsseite gegenüberliegenden Seite des Leuchtenmoduls, insbesondere auf der Rückseite der Platine, vorgesehen sein, welche im an der Leuchte angeschlossenen Zustand des Leuchtenmoduls eine Abdichtung gegenüber einem angrenzenden Bauteil der Leuchte bildet. Mittels dieser Dichtung lassen sich z.B. feuchtigkeitsgeschützte, spritzwassergeschützte oder strahlwassergeschützte Leuchten herstellen. Bei der Verwendung von Dichtungsmaterial in den Steckern lassen sich noch höhere Schutzarten von Leuchten fertigen. Ferner können die Leuchtenmodule auch gasdicht ausgebildet sein und mittels der Dichtung mit der Leuchte gasdicht verbunden werden. Diese Leuchten eignen sich für den Einsatz in Umgebungen mit explosionsgefährlichen Gasen.

Gemäß einer bevorzugten Ausführungsform umfasst das Leuchtenmodul ferner auf der Platine Betriebsmittel zur Versorgung der LEDs. Insbesondere kann ein Vorschaltgerät oder ein LED-Treiber auf der Platine angeordnet sein. Gemäß einer bevorzugten Ausführungsform sind die Betriebsmittel auf der Bestückungsseite der Platine angeordnet. Diese Ausführungsformen haben den Vorteil, dass der Austausch defekter Betriebsmittel mit dem Leuchtenmodul erfolgen kann. Ferner ist leuchtenseitig nur die Versorgungsleitung für die LED-Module unterzubringen.

Gemäß einer bevorzugten Ausführungsform ist das Leuchtenmodul in der Querschnittsebene entlang der Platine rechteckig oder quadratisch. Diese Ausführungsform ist insbesondere von Vorteil in Leuchten, in denen dicht an dicht mehrere Leuchtenmodule eingefügt werden. Mit rechteckigen oder quadratischen Leuchtenmodulen lassen sich z.B. Lichtbänder mit mehreren hintereinander und/oder nebeneinander angeordneten Leuchtenmodulen bilden.

Ein Aspekt der Erfindung betrifft ferner eine Leuchte für Beleuchtungszwecke, z.B. eine Innen- oder Außenleuchte, die ein oder mehrere der vorhergehend beschriebenen Leuchtenmodule umfasst. Die Leuchte kann z.B. mehrere Leuchtenmodule aufweisen, die hintereinander angeordnet sind, um ein Lichtband zu bilden. Die Leuchte kann insbesondere eine Durchgangsverdrahtung aufweisen, an der hintereinander mehrere Gegenkupplungsstücke angeschlossen sind, in welche jeweils ein Leuchtenmodul einsteckbar ist.

Gemäß einer weiteren Ausführungsform kann die Leuchte auch als Einzelleuchte, insbesondere als Downlight, ausgebildet sein. Das Downlight kann ein Leuchtenmodul oder mehrere z.B. symmetrisch angeordnete Leuchtenmodule aufweisen.

Weitere Merkmale und Vorteile der vorliegenden Erfindung werden aus der nachfolgenden Beschreibung bevorzugter Ausführungsformen deutlich. In den beigefügten Figuren ist/sind
- Figur 1: ein Querschnitt durch einen Teil einer Leuchte mit einem Leuchtenmodul,
- Figur 2: eine Aufsicht auf das Leuchtenmodul nach Figur 1,
- Figur 3: ein Querschnitt durch ein Leuchtenmodul nach einer weiteren Ausführungsform,
- Figur 4: eine Vergrößerung eines Ausschnitts der Figur 3,
- Figuren 5a-5c: perspektivische Ansichten von drei Leuchten,
- Figur 6: eine perspektivische Ansicht einer Lichtbandleuchte mit einem Leuchtenmodul, und
- Figuren 7a-7b: perspektivische Ansichten von zwei Leuchtenmodulen.

Ein Leuchtenmodul der dargestellten Ausführungsformen umfasst eine Platine 2, die eine Bestückungsseite 4 und eine gegenüberliegende Rückseite 6 aufweist. Die Platine 2 ist auf der Bestückungsseite 4 mit mehreren LEDs 8 bestückt. Auf der Bestückungsseite 4 befinden sich ferner Leiterbahnen (in den Figuren nicht dargestellt), welche die LEDs 8 elektrisch kontaktieren.

Gemäß den dargestellten Ausführungsformen ist die Platine 4 eine einseitig leitende Platine, welche nur auf der Bestückungsseite 4, auf der die LEDs 8 angeordnet sind, mit elektrischen Leiterbahnen ausgebildet ist.

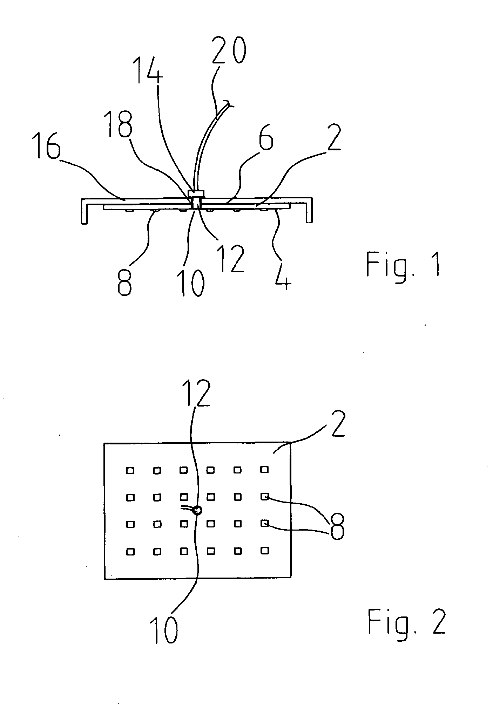

Die Platine 6 gemäß dem in Figur 1 und 2 gezeigten Leuchtenmodul umfasst ferner eine Öffnung 10, welche dazu dient, eine elektrische Verbindung zur Rückseite 6 der Platine zu bilden. Dazu ist im Bereich der Öffnung 10 in elektrischer Verbindung mit der Bestückungsseite 4 bzw. den darauf vorgesehenen Leiterbahnen ein Kupplungsstück 12 eines elektrischen Steckers angebracht. Das Kupplungsstück 12 erstreckt sich durch die Öffnung 10 zur Rückseite 6 der Platine 2. Auf der Rückseite 6 kann ein leuchtenseitig vorgesehenes Gegenkupplungsstück 14 mit dem Kupplungsstück 12 in Kotakt gebracht werden. Das Gegenkupplungsstück 14 ist an einem Gehäuseabschnitt 16 der Leuchte fest vorgesehen. Die Steckerverbindung ist derart ausgeführt, dass sie die notwendige Stabilität aufweist, um das Leuchtenmodul an dem Gehäuse 16 der Leuchte mechanisch zu halten. Ferner bildet die Steckverbindung die einzige elektrische Kontaktierung zu dem Leuchtenmodul. Alle elektrischen Versorgungsleitungen werden durch die Steckverbindung zu dem Leuchtenmodul übertragen. An dem Gegenkupplungsstück 14 ist eine Anschlussleitung 20 angebracht, die vorzugsweise bereits bei der Herstellung der Leuchte fest am Leuchtengehäuse montiert ist. Die Steckverbindung zwischen dem Kupplungsstück 12 und dem Gegenkupplungsstück 14 ist dagegen so ausgeführt, dass sie leicht von einem Monteur vor Ort bei der Montage der Leuchte oder bei Wartungsarbeiten verbunden und wieder gelöst werden kann.

In der dargestellten Ausführungsform des Leuchtenmoduls nach Figur 1 und 2 ist ferner auf der Rückseite 6 der Platine 2 um das Kupplungsstück 12 eine Dichtung 18 vorgesehen, welche im montierten Zustand des Leuchtenmoduls eine staub- und feuchtigkeitsdichte Kapselung bewirkt, so dass kein Staub und keine Feuchtigkeit zwischen der Rückseite 6 der Platine und dem angrenzenden Abschnitt des Leuchtengehäuses 16 in die Leuchte eindringen können.

Auf der Bestückungsseite der LED ist ferner eine Isolierung in Form eines transparenten Überzuges (z.B. aus einem transparenten Kunststoffharz) vorgesehen, welcher sämtliche Leiterbahnen und den Anschluss des Kupplungsstücks 12 isoliert. Die Isolierung dient dem Berührungsschutz bei Montage-, Wartungs- oder Reinigungsarbeiten der Leuchte. Ferner kann die Isolierung gemäß einer Ausführungsform auch feuchtigkeitsdicht ausgeführt werden. Zusammen mit der Dichtung 18 auf der Rückseite der Platine ist das Leuchtenmodul daher vollständig gegen die Umgebung abgedichtet. Derartige Leuchten können beispielsweise in Feuchträumen eingesetzt werden. Mit einer gasdichten Abdichtung können derartige Leuchten in Räumen eingesetzt werden, in denen eine erhöhte Gefahr zur Ansammlung von explosiven Gasen besteht.

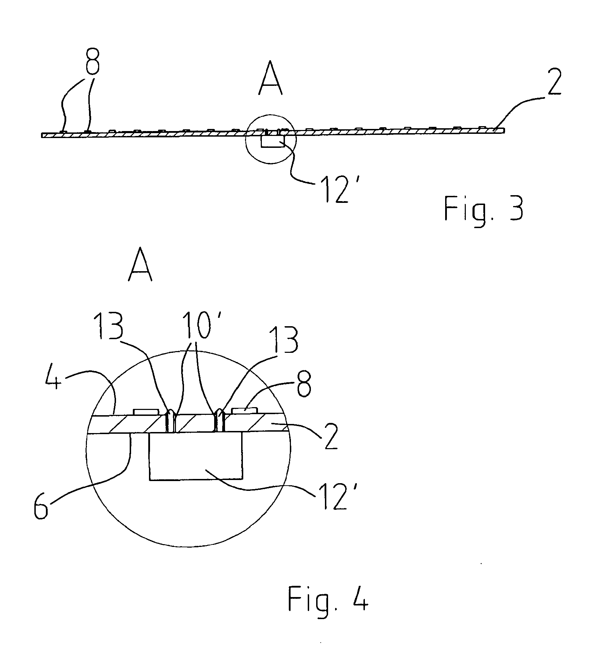

Bezug nehmend auf die Figuren 3 und 4 ist eine alternative Ausführungsform eines Leuchtenmoduls dargestellt, wobei für entsprechende Elemente die gleichen Bezugszeichen wie in Figuren 1 und 2 verwendet wurden. Bei dieser Ausführungsform ist ein Kupplungsstück 12' auf der Rückseite der Platine 2 angeklebt, wobei der Klebstoff gleichzeitig als Dichtung dient und daher entsprechend der Dichtung 18 der vorhergehend beschriebenen Ausführungsform wirkt. Das Kupplungsstück 12' weist zwei metallische Kontaktstifte 13 auf, die durch zwei Öffnungen 10' in der Platine 2 von der Rückseite 6 zur Bestückungsseite 4 hindurchgeführt werden und gemäß dieser Ausführungsform die elektrische Verbindung von der Rückseite 6 zur Bestückungsseite 4 der Platine bilden. Die Kontaktstifte 13 sind nur auf der Bestückungsseite mit elektrischen Leiterbahnen (in den Figuren nicht dargestellt) verbunden, um die elektrische Versorgung der LEDs 8 zu ermöglichen. In das Kupplungsstück 12' kann ebenso wie bei den vorhergehend beschriebenen Ausführungsformen in ein Gegenkupplungsstück 14, welches leuchtenseitig montiert ist, eingreifen.

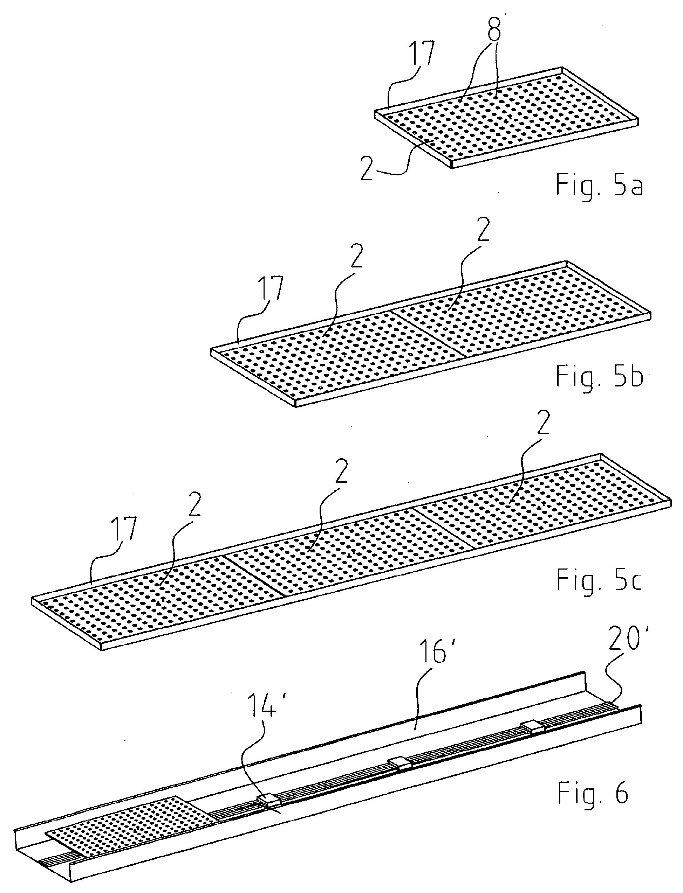

In den Figuren 5a bis c sind drei verschiedene Ausführungsformen von Leuchten offenbart, die jeweils eine, zwei bzw. drei Leuchtenmodule, wie in den Figuren 3 und 4 dargestellt, aufweisen. Das Leuchtengehäuse umfasst einen Rahmen 17, der die Größe von ein, zwei bzw. drei Leuchtenmodulen passgenau aufnehmen kann. Die Leuchtenmodule sind wie vorhergehend beschrieben von der Bestückungsseite durch eine Vergussmasse wasserdicht isoliert. Ferner ist in der Verbindung zwischen dem Kupplungsstück und dem Gegenkupplungsstück (in den Figuren 5a bis 5c nicht zu sehen) eine Dichtung vorgesehen, so dass durch diese Steckverbindung ebenfalls keine Feuchtigkeit eintreten kann. Die Leuchten gemäß den Figuren 5a bis 5c können insbesondere als Feuchtraumleuchten ausgebildet sein, wobei durch die Kapselung des einen oder der mehreren Leuchtenmodule keine weitere Isolierung, außer der Kabelisolierung innerhalb der Leuchte, notwendig ist. Gemäß einer alternativen Ausführungsform der Feuchtraumleuchten kann auch leuchtenseitig an dem Gehäuserahmen 17 eine transparente Abdeckung über dem oder den Leuchtenmodulen vorgesehen sein, welche z.B. einen feuchtigkeitsdichten Abschluss der Leuchte gewährleistet.

In der Figur 6 ist eine Leuchte in Form einer Lichtbandleuchte dargestellt. Bei dieser Ausführungsform werden eine Vielzahl von Leuchtenmodulen (in Figur 6 ist nur ein Leuchtenmodul dargestellt) hintereinander eingesteckt. Die Leuchte ist aus einem Gehäuse 16' in Form einer sich in einer Richtung längs erstreckenden Wanne oder Montageschiene gebildet. Innerhalb der Wanne, etwa entlang der Mittellinie, ist eine Durchgangsverdrahtung 20' angeordnet, welche als Anschlussleitung für die Leuchtenmodule dieser Ausführungsform dient. An der Durchgangsverdrahtung 20' sind hintereinander vorzugsweise in regelmäßigen Abständen Gegenkupplungsstücke 14 angeordnet, in die jeweils ein Kupplungsstück eines Leuchtenmoduls eingesteckt werden kann.

Die Leuchtenmodule werden alleine durch die Verbindung zwischen dem Kupplungsstück und dem Gegenkupplungsstück in dem Gehäuse 16 gehalten.

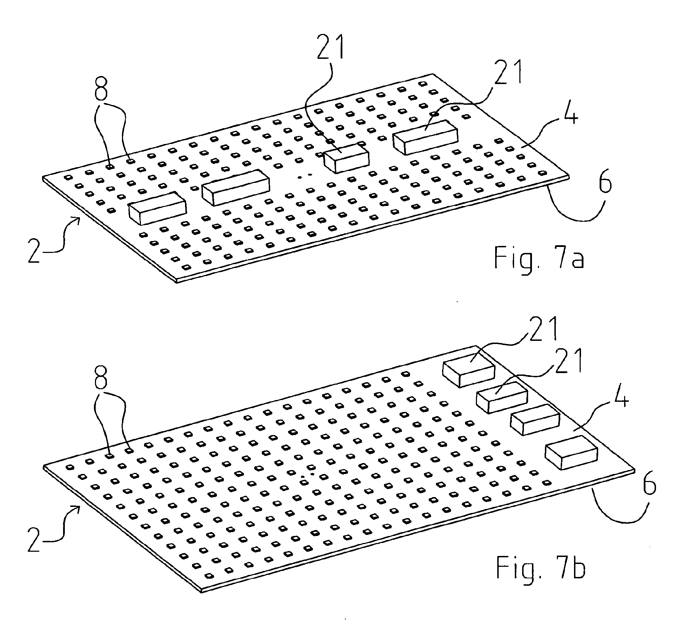

In den Figuren 7a und 7b sind zwei weitere Ausführungsformen von Leuchtenmodulen dargestellt. Bei diesen Leuchtenmodulen sind auf der Bestückungsseite Betriebsmittel in Form von LED-Treibern 21 angeordnet. Die Betriebsmittel können in unterschiedlicher Anordnung, z.B. entlang der Mittellinie oder an einem Rand der Platine 2, wie in den Figuren 7a und 7b beispielhaft dargestellt, angeordnet sein. Diese Leuchtenmodule können in einer Leuchte montiert werden, die lediglich die Spannungsversorgung für die LED-Treiber liefert. Die vollständige zum Betrieb der LEDs 8 notwendige Elektronik ist in dem Leuchtenmodul integriert.

Weitere Ausführungsformen von Leuchtenmodulen und zugehörigen Leuchten, wie sie in den nachfolgenden Ansprüchen definiert sind, sind im Rahmen der Erfindung möglich. Beispielsweise kann die Leuchte auch als ein Downlight ausgebildet sein, in der vorzugsweise nur ein Leuchtenmodul vorgesehen ist. Alle gezeigten Ausführungsformen weisen jeweils nur ein Kupplungsstück auf. Obgleich dies für die Erfindung bevorzugt ist, können jedoch auch mehrere Kupplungsstücke an einem Leuchtenmodul vorgesehen sein. Vorzugsweise ist das wenigstens eine Kupplungsstück auf einer Mittellinie der Platine angeordnet. Es können auch mehrere Kupplungsstücke entlang einer Mittellinie der Platine vorgesehen sein. Die Größe der Kupplungsstücke ist im Verhältnis zu den Platinen sehr viel kleiner, beispielsweise beträgt die Querschnittsabmessung eines Kupplungsstücks in der Ebene der Platine nur weniger als 10% des entsprechenden Querschnittsabmessung der Platine. Dadurch ist es möglich, verhältnismäßig viele LEDs auf der Bestückungsseite der Leuchtenmodule anzuordnen. Im Unterschied zu herkömmlichen Leuchtmitteln, die teilweise mit LEDs ausgebildet sind, ermöglichen es die Leuchtenmodule gemäß der vorliegenden Erfindung, eine Isolierung zu bilden, ohne dass hierfür ein separates Gehäuse des Leuchtenmoduls erforderlich ist. Durch die Verwendung von einseitig leitenden Platinen ist es nicht einmal notwendig, die der Bestückungsseite gegenüberliegende Rückseite des Leuchtenmoduls mit einer separaten Isolierung zu versehen.

### Bezugszeichenliste:

- 2: Platine
- 4: Bestückungsseite
- 6: Rückseite
- 8: LED
- 10, 10': Öffnung
- 12, 12': Kupplungsstück
- 13: elektrischer Stift
- 14, 14': Gegenkupplungsstück
- 16: Gehäuse
- 17: Gehäuserahmen
- 18: Dichtung
- 20, 20': Anschlussleitung
- 21: LED-Treiber

## Patentansprüche

1. Leuchte, die ein oder mehrere Leuchtenmodule zum Anschluss an eine Leuchte aufweist, wobei das wenigstens eine Leuchtenmodul eine Platine mit einer Bestückungsseite (4) aufweist, auf der mehrere LEDs (8) und elektrische Leiterbahnen zum elektrischen Kontaktieren der LEDs angeordnet sind,
wobei die Platine (2) wenigstens eine Öffnung (10, 10') aufweist und ein Kupplungsstück (12, 12') einer Steckerverbindung an der Platine im Bereich der Öffnung fest montiert ist, in welches ein leuchtenseitiges Gegenkupplungsstücks (14), welches an einem Gehäuseabschnitt (16) der Leuchte fest vorgesehen ist, von der der Bestückungsseite gegenüberliegenden Rückseite (6) der Platine (2) eingreifen kann, wobei durch die Öffnung (10) eine elektrische Verbindung von der Bestückungsseite (4) zu der Rückseite (6) der Platine (2) gebildet wird, um die LEDs (8) von der Rückseite des Leuchtenmoduls mit elektrischer Leistung zu versorgen.

2. Leucht nach Anspruch 1, wobei das Kupplungsstück (12) im Bereich der Öffnung (10) auf der Bestückungsseite (4) der Platine (2) montiert ist und von der Bestückungsseite (4) durch die Öffnung (10) hindurchgreift, um die elektrische Verbindung zu bilden, oder auf der Bestückungsseite (4) derart montiert ist, dass das leuchtenseitige Gegenkupplungsstück (14) durch die Öffnung (10) zum Eingriff in das Kupplungsstück hindurchgeführt kann, um die elektrische Verbindung zu bilden.

3. Leuchte nach Anspruch 1, wobei das Kupplungsstück (12') im Bereich der wenigstens einen Öffnung (10') auf der Rückseite der Platine montiert ist und die elektrische Verbindung verbindet das Kupplungsstück mit der Bestückungsseite durch die wenigstens eine Öffnung (10').

4. Leuchte nach Anspruch 2 oder 3, bei welcher die Steckerverbindung dafür eingerichtet ist, das Leuchtenmodul mechanisch in der Leuchte zu halten.

5. Leuchte nach einem der vorhergehenden Ansprüche, wobei die Platine (2) nur einseitig auf der Bestückungsseite (4) leitend ist.

6. Leuchte nach einem der vorhergehenden Ansprüche, wobei zwischen dem Kupplungsstück (12, 12') und der Platine (2) eine Isolierung oder eine Dichtung angeordnet ist.

7. Leuchte nach einem der vorhergehenden Ansprüche, wobei die Platine (2) auf der Bestückungsseite (4) vollständig oder teilweise mit einer elektrischen Isolierung überzogen ist, wobei die Isolierung insbesondere durch eine Vergussmasse, insbesondere durch eine transparente Vergussmasse, gebildet ist.

8. Leuchtenmodul nach einem der vorhergehenden Ansprüche, welches vollständig elektrisch isoliert ist, derart, dass es gegen eine elektrostatische Entladung (ESD) geschützt ist.

9. Leuchte nach einem vorhergehenden Ansprüche, wobei eine Dichtung auf der der Bestückungsseite (4) gegenüberliegenden Seite des Leuchtenmoduls, insbesondere der Platine (2), vorgesehen ist, welche im an der Leuchte angeschlossenen Zustand des Leuchtenmoduls eine Abdichtung gegenüber einem angrenzenden Bauteil der Leuchte bildet, und das Leuchtenmodul feuchtigkeitsgeschützt und/oder gasgeschützt ist.

10. Leuchte nach einem der vorhergehenden Ansprüche, welches in der Querschnittsebene entlang der Platine (2) rechteckig oder quadratisch ist.

11. Leuchte nach einem der vorhergehenden Ansprüche, welches ferner Betriebsmittel zur Versorgung der LEDs (8), insbesondere ein oder mehrere Vorschaltgeräte oder LED-Treiber (21), auf der Platine (2) aufweist.

12. Leuchte nach einem der vorhergehenden Ansprüche, in welcher mehrere der Leuchtenmodule als Lichtband angeordnet sind.

13. Leuchte nach einem der vorhergehenden Ansprüche, welche eine Durchgangsverdrahtung (20') aufweist, an der hintereinander mehrere Gegenkopplungsstück (14) angebracht sind, an welche die Leuchtenmodule einsteckbar sind.

14. Leuchte nach einem der vorhergehenden Ansprüche, welche als Einzelleuchte, insbesondere als Feuchtraumleuchte oder Downlight, ausgebildet ist.

## Claims

1. Lights comprising one or more light modules for connection to a light, wherein the at least one light module comprising a circuit board with a population face (4), on which a plurality of LED's (8) and electrical conductor tracks for making electrical contact with the LED's are arranged, wherein the circuit board (2) has at least one opening (10, 10') and a coupling piece (12, 12') of a plug connection is fixed to the board in the area of the opening, in which a mating coupling piece (14) on the light side, which is fixed to a housing section (16) of the light, can engage from the rear face (6) of the board (2) opposite the population face, an electrical contact is formed through the opening (10) from the population face (4) to the rear face (4) of the board (2), in order to supply the LED's (8) with electrical power from the rear face of the light module.

2. Light according to claim 1, wherein the coupling piece (12) is fixed in the area of the opening (10) on the population face (4) of the circuit board (2) and engages from the population face (4) through the opening (10) in order to from the electrical connection, or is fixed on the population face (4) in such a way that the mating coupling piece (14) on the light side can be introduced through the opening (10) to engage into the coupling piece in order to form the electrical connection.

3. Light according to claim 1, wherein the coupling piece (12') is fixed in the area of the at least one opening (10') on the rear face of the circuit board and the electrical connection connects the coupling piece with the population face through the at least one opening (10').

4. Light according to claim 2 or 3, wherein the plug connection is arranged in such a way as to hold the light module mechanically in the light.

5. Light according to one of the preceding claims, wherein the circuit board (2) is only conductive on one side on the population face (4).

6. Light according to one of the preceding claims, wherein an isolation piece or seal is arranged between the coupling piece (12, 12') and the circuit board (2).

7. Light according to one of the preceding claims, wherein the circuit board (2) on the population face (4) is covered completely or partially with an electrical insulation, wherein the insulation is formed by a cast compound, in particular by a transparent cast compound.

8. Light module according to one of the preceding claims, which is completely electrically insulated in such a way that it is protected against electrostatic discharge (ESD).

9. Light according to one of the preceding claims, wherein a seal is provided on the side of the light module, in particular of the circuit board (2) opposite the population face (4), which, in the state of the light module being connected to the lights, forms a seal against an adjacent component of the lights, and the light module is protected against moisture and/or gas.

10. Light according to one of the preceding claims, which in the cross-section plane along the circuit board (2) is rectangular or square.

11. Light according to one of the preceding claims, which also comprises operating means for supplying the LED's (8), in particular one or more choke devices or LED drivers (21), on the circuit board (2).

12. Light according to one of the preceding claims, in which a plurality of the light modules are arranged as a light strip.

13. Light according to one of the preceding claims, having a through wiring (20') on which a plurality of mating coupling pieces (14) are located, into which the light modules can be plugged.

14. Light according to one of the preceding claims, which is formed as a single light, in particular as a wet room light or downlight.

## Revendications

1. Luminaire qui présente un ou plusieurs modules de luminaire pour la connexion à un luminaire, dans lequel l'au moins un module de luminaire présente une platine avec un côté de montage (4), sur lequel sont agencées plusieurs LED (8) et pistes conductrices électriques pour la mise en contact électrique des LED,
étant entendu que la platine (2) présente au moins une ouverture (10, 10') et qu'une pièce de couplage (12, 12') d'une connexion à fiches est montée de façon fixe sur la platine dans la zone de l'ouverture, une pièce de contre-couplage du côté du luminaire (14), qui est prévue de façon fixe sur une section de logement (16) du luminaire, pouvant s'engager dans la pièce de couplage (12, 12') à partir du côté arrière (6) de la platine (2) opposé au côté de montage, étant entendu qu'une connexion électrique depuis le côté de montage (4) vers le côté arrière (6) de la platine (2) est formée à travers l'ouverture (10) pour alimenter les LED (8) en courant électrique depuis le côté arrière du module de luminaire.

2. Luminaire selon la revendication 1, dans lequel la pièce de couplage (12) est montée sur le côté de montage (4) de la platine (2) dans la zone de l'ouverture (10) et s'engage à travers l'ouverture (10) depuis le côté de montage (4) pour former la connexion électrique ou elle est montée sur le côté de montage (4) de telle sorte que la pièce de contre-couplage du côté du luminaire (14) peut être guidée à travers l'ouverture (10) pour s'engager dans la pièce de couplage afin de former la connexion électrique.

3. Luminaire selon la revendication 1, dans lequel la pièce de couplage (12') est montée sur le côté arrière de la platine dans la zone de l'au moins une ouverture (10') et la connexion électrique relie la pièce de couplage avec le côté de montage à travers l'au moins une ouverture (10').

4. Luminaire selon la revendication 2 ou 3, dans lequel la connexion à fiches est conçue pour maintenir le module de luminaire mécaniquement dans le luminaire.

5. Luminaire selon l'une des revendications précédentes, dans lequel la platine (2) est seulement conductrice d'un seul côté sur le côté de montage (4).

6. Luminaire selon l'une des revendications précédentes, dans lequel une isolation ou un joint d'étanchéité est agencé entre la pièce de couplage (12, 12') et la platine (2).

7. Luminaire selon l'une des revendications précédentes, dans lequel la platine (2) est recouverte entièrement ou partiellement par une isolation électrique sur le côté de montage (4), étant entendu que l'isolation est formée en particulier par une masse de scellement, en particulier par une masse de scellement transparente.

8. Module de luminaire selon l'une des revendications précédentes, qui est entièrement isolé électriquement de telle sorte qu'il est protégé contre une décharge électrostatique (ESD).

9. Luminaire selon l'une des revendications précédentes, dans lequel il est prévu un joint d'étanchéité sur le côté du module de luminaire, en particulier de la platine (2), opposé au côté de montage (4), lequel forme une étanchéité par rapport à un composant adjacent du luminaire dans l'état raccordé au luminaire du module de luminaire, et le module de luminaire est protégé contre l'humidité et/ou protégé contre le gaz.

10. Luminaire selon l'une des revendications précédentes, qui est rectangulaire ou carré dans le plan de la section le long de la platine (2).

11. Luminaire selon l'une des revendications précédentes, qui présente en outre des moyens de fonctionnement pour l'alimentation des LED (8), en particulier un ou plusieurs ballasts ou pilotes de LED (21), sur la platine (2).

12. Luminaire selon l'une des revendications précédentes, dans lequel plusieurs des modules de luminaire sont agencés sous forme de bande de lumière.

13. Luminaire selon l'une des revendications précédentes, qui présente un câblage traversant (20') sur lequel plusieurs pièces de contre-couplage (14), sur lesquelles les modules de luminaire peuvent être enfichés, sont installées l'une derrière l'autre.

14. Luminaire selon l'une des revendications précédentes, qui est réalisé en tant que luminaire individuel, en particulier en tant que luminaire pour locaux humides ou luminaire encastré.
